Europäisches Patentamt

European Patent Office

Office européen des brevets

(11) Numéro de publication: **0 375 519**
**A1**

## (12) DEMANDE DE BREVET EUROPEEN

(21) Numéro de dépôt: 89403486.7

(22) Date de dépôt: 14.12.89

(51) Int. Cl.5 **H01G 13/00**

(30) Priorité: 23.12.88 FR 8817090

(43) Date de publication de la demande:
27.06.90 Bulletin 90/26

(84) Etats contractants désignés:
BE DE GB IT NL

(71) Demandeur: COMPAGNIE EUROPEENNE DE
COMPOSANTS ELECTRONIQUES LCC
50, rue Jean-Pierre Timbaud
F-92400 Courbevoie(FR)

(72) Inventeur: **Dorlanne, Olivier**
THOMSON-CSF SCPI Cédex 67
F-92045 Paris la Défense(FR)
Inventeur: **Petit, Dominique**
THOMSON-CSF SCPI Cédex 67
F-92045 Paris la Défense(FR)

(74) Mandataire: **Taboureau, James et al**
THOMSON-CSF SCPI
F-92045 Paris La Défense Cédex 67(FR)

(54) **Bande de connexions pour assemblage en ligne de composants CMS.**

(57) L'invention concerne une bande métallique (1) prédécoupée, destinée à l'assemblage de composants montables en surface (CMS), à partir de pastilles ayant deux métallisations sur deux faces opposées.

Chaque position de composant, délimitée par deux fentes transversales (3,4), comprend deux connexions extérieures (5,6), prolongées, chacune, par une pièce de reprise de contact. Celle-ci est caractérisée par une forme recourbée, constituée par une surface à souder (9,10) et une languette (10,11), de sorte que, après pliage (13,14) pour créer un espace pour le composant, les surfaces à souder (9,10) se recouvrent (R) partiellement, formant une pince pour le composant.

Application à la fabrication des composants CMS.

FIG.5

## BANDE DE CONNEXIONS POUR ASSEMBLAGE EN LIGNE DE COMPOSANTS CMS

La présente invention concerne une bande de connexions utilisée au cours du montage en ligne de fabrication automatisée de composants dits CMS, c'est-a-dire composants pour le montage en surface. Cette bande de connexions est adaptée a des composants ayant deux électrodes sur deux faces opposées de leur corps : ce sont soit des disques de condensateurs céramiques ou de varistances, soit des pastilles de diodes, soit des composants sous forme parallélépipèdique.

On sait que le montage en surface est une technologie qui permet d'importants gains de productivité, en association avec les machines d'implantation automatique, et que cette technologie évite de percer les circuits imprimés ou les substrats céramiques, comme cela est nécessaire avec les composants à sorties axiales ou latérales, par fils. Mais elle exige que les composants soient munis d'au moins deux connexions d'accès sur une même face du composant, de façon a pouvoir être brasées sur une face d'un substrat de report. Les avantages apportés par la technologie CMS ne sont valables que si les composants CMS sont eux-mêmes produits en grandes séries, sur des lignes automatisées.

L'invention répond a cette nécessité en proposant une bande métallique, adaptée a la fabrication en ligne. Cette bande, perforée sur ses bords pour assurer son avance et son positionnement, supporte une pluralité de jeux de connexions prédécoupées. Considéré pour un composant, un jeu de connexions comprend, transversalement par rapport a la bande, deux lames de connexions extérieures solidaires, chacune, d'une pièce de reprise de contact pour la brasure sur le disque du composant. Les deux pièces de reprise de contact sont découpées, dans la bande plane, avec une forme imbriquée, ou en crochet, de telle façon qu'après un double pliage qui crée entre elles l'espace d'insertion du composant, il y a superposition d'une partie des pièces de reprise de contact, qui forment ainsi une pince qui maintient le composant. Les deux parties superposées des pièces de reprise de contact sont en outre munies de soudure apportée sous une forme appropriée (préforme, pâte à braser...) de sorte qu'il suffit de chauffer au four à passage ou à la microsoudeuse, après l'insertion du composant, pour que celui-ci soit brasé et muni de deux connexions extérieures, situées dans un même plan et dans le prolongement l'une de l'autre.

De façon plus précise, l'invention concerne une bande de connexions pour l'assemblage en ligne d'une pluralité de composants électroniques pour montage en surface (CMS), chaque composant se présentant sous forme d'une pastille munie sur ses deux faces opposées de deux métallisations, cette bande de connexion, découpée dans un ruban métallique muni de trous latéraux pour son positionnement en ligne, étant caractérisée en ce que chaque position de composant comporte, définies par deux fentes transversales par rapport au ruban, deux connexions extérieures dans le prolongement l'une de l'autre, chacune des connexions étant réunie par un pli a une pièce de reprise de contact formée par une languette et par une surface à souder recourbée par rapport a la languette, de telle sorte qu'une partie d'une première surface à souder recouvre (R) une partie de la deuxième surface à souder, formant ainsi une pince qui maintient le composant pendant les opérations d'assemblage, les plis étant de directions opposées.

L'invention sera mieux comprise par la description qui suit d'un exemple d'application, en liaison avec les figures jointes en annexes, qui représentent :

- figure 1 : un élément de bande de connexions, plane, après découpe.
- figures 2, 3 , 4 : trois variantes de découpe des pièces de reprise de contact.
- figure 5 : un élément de bande de connexions, après pliage et apport de soudure.
- figure 6 : deux variantes possibles, représentées sur la même figure, de découpe des connexions extérieures.
- figures 7 et 8 : deux vues de 3/4 dans l'espace de deux composants CMS, correspondant aux variantes de découpe de la figure 6.
- figure 9 : élément de bande de connexions munie d'ergots de centrage du composant.
- figure 10 : vue en coupe montrant le pliage de la bande pour centrage du composant.

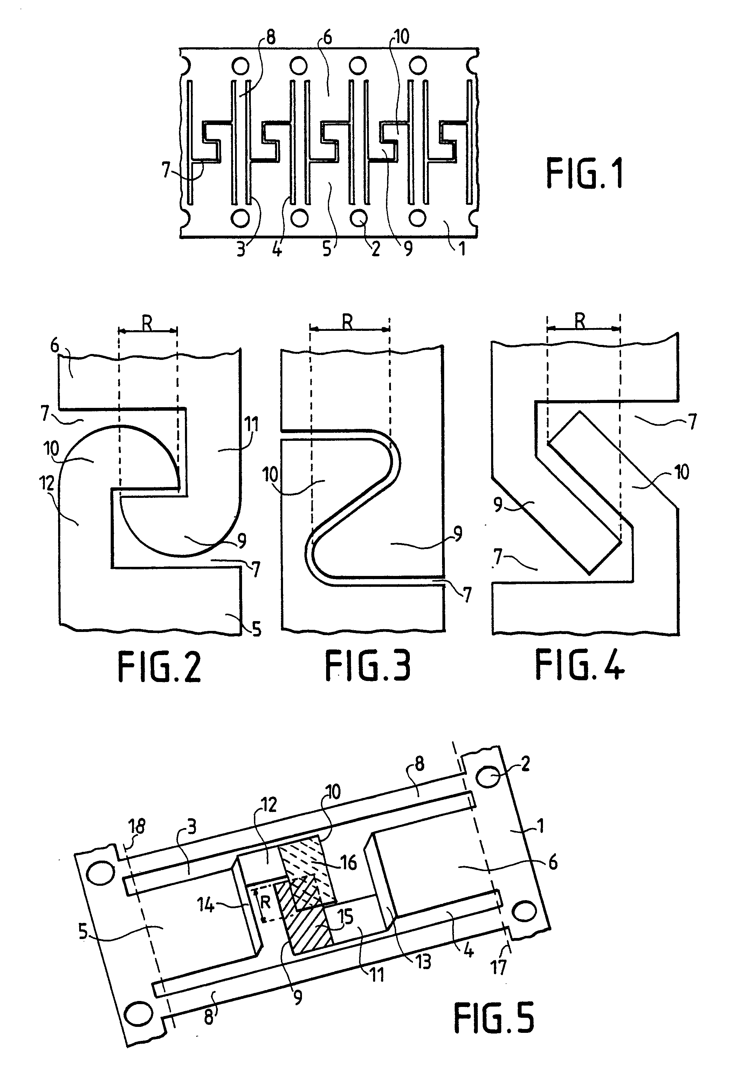

La figure 1 représente un élément de bande de connexions selon l'invention : cet élément correspond à 5 positions de composants, coupées dans une bande prévue pour plusieurs milliers de composants.

Il s'agit d'un ruban métallique 1, dans lequel sont découpés, par voie mécanique ou chimique :
- des trous 2, sur les bords du ruban, pour assurer son avance et son positionnement précis,
- des fentes 3 et 4, parallèles entre elles et transversales par rapport au ruban 1 : ces fentes définissent les connexions d'accès extérieur 5 et 6 au composant CMS,
- une découpe 7 entre chaque paire de fentes 3 et 4.

Les fentes transversales 3 et 4 correspondant à un composant CMS sont séparées des fentes transversales des deux composants voisins par une bande métallique 8. Cette bande d'espacement permettra ultérieurement d'enrober chaque composent CMS par un surmoulage en résine synthétique. On verra plus loin que cette bande d'espacement 8 peut porter des ergots - qui ne sont pas représentés sur la figure 1 - qui facilitent la fabrication des composants CMS.

Entre chaque paire de fentes 3 et 4, la découpe 7, qui atteint lesdites fentes, a une forme complexe recourbée, en grecque telle que représentée en figure 1, ou en crosses telle que représentées sur les détails agrandis des figures 2 à 4.

L'objet de cette découpe est de définir dans le ruban métallique 1 les pièces de reprises de contact 9 et 10, qui seront ultérieurement soudées sur les deux faces métallisées du composant CMS.

Ces pièces de reprises de contact ont une forme imbriquée, composée - voir en figure 2 - d'une surface à souder 9 et 10, et d'une languette 11 et 12 qui réunit, respectivement, la surface 9 à la connexion extérieure 6, et la surface 10 à la connexion extérieurè 5. La forme imbriquée peut être obtenue au moyen d'un découpe en grecque (figure 1), en grecque arrondie (figure 2), en S (figure 3) ou par deux bandes diagonales (figure 4) par exemple, bien que de nombreuses autres formes soient prévisibles.

Le seul impératif dans la forme de la découpe 7, outre l'impératif de largeur pour assurer le passage du courant, est d'obtenir une zone de recouvrement entre surfaces à souder 9 et 10, notée R sur les figures 2 à 4, lorsque, dans un stade ultérieur, les connexions extérieures 5 et 6 et les languettes 11 et 12 seront pliées, pour créer l'espace a l'intérieur duquel le disque du composant sera inséré.

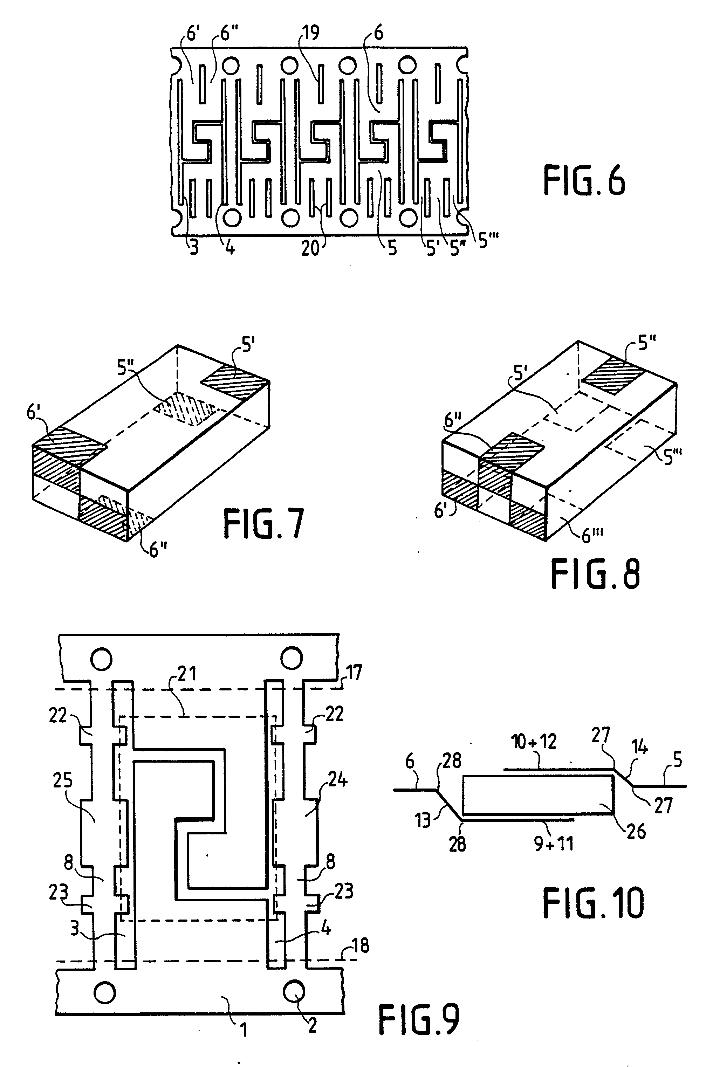

En effet, l'ensemble des figures 1 à 4 correspond à un premier état de la bande de connexions, qui est encore plane. Cette bande de connexions n'est pas exploitable en l'état, parce que les pièces de reprises de contact sont coplanaires. Il faut créer entre elles un espace par pliages, tel que montré en figure 5.

Pour être plus facilement lisible, cette figure ne représente qu'une seule position, pour un seul composant, de la bande de connexions, mais dans un second état, prêt à l'insertion d'un disque de composant sur une machine de fabrication.

Un double pliage des connexions extérieures 5 et 6 et des languettes 11 et 12 crée deux plis 13 et 14, un pour chaque connexion. Par cette opération :

- les pièces de reprises de contact reculent, et les surfaces à souder 9 et 10 se recouvrent partiellement,

- un espacement est créé entre les pièces de reprises de contact : la hauteur de cet espacement est réglée par le pliage précédent et égal à la somme des hauteurs des plis 13 et 14 plus l'épaisseur de la bande de connexion, si le pliage est à angles droits.

La dernière opération consiste à munir les surfaces à souder 9 et 10 d'un alliage de soudure, représenté en traits continus en 15 et en traits discontinus en 16 (elle est sous la surface 10, donc cachée). L'alliage de soudure peut être apporté de différentes façons :

- fixation d'une préforme d'alliage clipsée sur une surface à souder,
- fixation d'une préforme d'alliage sertie sur une surface à souder à travers un trou pratiqué dans celle-ci,
- dépôt d'une crème à souder ou d'une colle conductrice,
- étamage au trempé,... etc.

La bande de connexions selon l'invention est alors prête à l'emploi : par une torsion transversale de bande, les connexions s'écartent et un disque de composant est introduit entre elles. Puis, la torsion étant supprimée, le composant est soudé sur ses connexions, au four à passage ou à la microsoudeuse, surmoulé par une résine synthétique et la bande, découpée longitudinalement selon les pointillés 17 et 18, libère les composants : il ne reste plus qu'à replier les connexions 5 et 6 contre le surmoulage pour obtenir un composant CMS.

Les figures suivantes représentent des perfectionnements de cette bande de connexions. Par exemple en figure 6, la bande de connexions, dans son premier état brut de découpe, peut comporter, pour chaque connexion extérieure 5 et 6, soit une fente 19, soit deux fentes 20 (les deux perfectionnements sont représentés sur la même figure, par simplification). Ces fentes sont parallèles aux fentes transversales 3 et 4 : la fente 19 découpe un connexion extérieure 6 en deux rubans égaux $6'$ et $6''$, et les fentes 20 découpent une connexion extérieure 5 en trois rubans $5'$, $5''$ et $5'''$. Pour plus de stabilité du CMS sur le circuit imprimé, il est préférable d'avoir une largeur de ruban $5''$ égale à la somme des largeurs $5'$ et $5'''$.

L'intérêt en est montré aux figures 7 et 8. Si la connexion extérieure est découpée une seule fois (19) les rubans peuvent être repliés sur deux faces principales du surmoulage plastique : le composant CMS sera fixé soit par les connexions $5'$ et $6'$, soit par les connexions $5''$ et $6''$. Il est symétrique, il n'est plus utile de l'orienter pour le positionner avant soudure.

Si la connexion extérieure est découpée deux fois (20), le résultat obtenu, en figure 8, est le même, mais avec l'avantage supplémentaire que le composant CMS obtenu est plus stable que celui de la figure 7 parce que les connexions extérieures sont alignées : $5'$ et $6'$, $5''$ et $6''$ sur une face, et $5'''$ et $6''$ sur l'autre face. Si le composant CMS est plus stable, il sera mieux soudé sur un support.

En figure 9 sont représentés deux perfectionnements liés aux bandes d'espacement 8 : ils peuvent être appliqués simultanément ou indépendamment. Par un rectangle pointillé 21 est représenté le futur surmoulage plastique du composant CMS. Après le surmoulage, la bande de connexions est découpée sur ses bords selon 17 et 18, et les composants CMS sont recueillis en vrac, ainsi que les bandes d'espacement 8.

Un premier perfectionnement consiste à munir les bandes d'espacement 8 de petits ergots tels que 22 et 23, s'avançant dans les fentes 3 et 4. Ces ergots sont positionnés pour être enrobés partiellement au cours du surmoulage et, lorsque les flancs de la bande de connexions sont découpés selon 17 et 18, les composants CMS enrobés ne sont plus en vrac : ils forment une chaîne, dont les bandes d'espacement 8 constituent les articulations. Ceci rend possible, par exemple, la numérotation des composants CMS ou leur test. En effet, il est préférable de tester les composants avant de les marquer afin de ne marquer que les bons. Une simple traction sur un composant le libérera des ergots 22,23 et des bandes d'espacement 8.

Un second perfectionnement consiste à munir les bandes d'espacement 8, dans leur partie centrale d'ergots tels que 24 et 25. Ceux-ci assureront le centrage du disque de composant lorsqu'il sera introduit entre les pièces de reprises de contact.

Une autre façon de centrer le disque de composant est représentée en figure 10. Soit 26 le disque de composant introduit entre les pièces de reprises de contact 9 + 11 et 10 + 12. Pour que les soudures soient bien centrées, le pliage des connexions extérieures 5 et 6 et des languettes 11 et 12 peut être contrôlé pour que les angles formés en 27 et 28 ne soient pas à 90° : par réglage de l'angle de pliage, le disque 26 de composant est autocentré par les plis 13 et 14.

La bande de connexions selon l'invention présente de nombreux avantages industriels, car elle a été étudiée en vue d'une fabrication en ligne totalement automatisée de composants CMS. Une même bande peut, par l'artifice du pliage des connexions et languettes, être adaptée à des composants d'épaisseurs variées, par exemple des condensateurs céramiques de valeurs dépendant de l'épaisseur du diélectrique. Mais par réduction des dimensions de la bande de connexion, celle-ci reste adaptée à des composants aussi petits que des pastilles de diodes. De façon plus générale, l'invention convient à tous les composants munis de deux électrodes sur deux faces opposées d'une pastille, qui doivent être montés en CMS.

**Revendications**

1. Bande de connexions pour l'assemblage en ligne d'une pluralité de composants électroniques pour montage en surface (CMS), chaque composant se présentant sous forme d'une pastille munie sur ses deux faces opposées de deux métallisations, cette bande de connexion, découpée dans un ruban métallique (1) muni de trous latéraux (2) pour son positionnement en ligne, étant caractérisée en ce que chaque position de composant comporte,. définies par deux fentes (3,4) transversales par rapport au ruban (1), deux connexions extérieures (5,6) dans le prolongement l'une de l'autre, chacune des connexions (5,6) étant réunie par un pli (13,14) à une pièce de reprise de contact formée par une languette (11,12) et par une surface à souder (9,10) recourbée par rapport à la languette 11,12, de telle sorte qu'une partie d'une première surface à souder (9) recouvre (R) une partie de la deuxième surface à souder (10), formant ainsi une pince qui maintient le composant pendant les opérations d'assemblage, les plis (13,14) étant de directions opposées.

2. Bande de connexions selon la revendication 1, caractérisée en ce que les pièces de reprise de contact sont munies, sur leurs surfaces à souder (9,10) de moyens de soudure choisis parmi :
- préforme d'alliage de soudure clipsée,
- préforme d'alliage de soudure sertie dans un trou pratiqué dans la surface à souder,
- crème à souder ou colle conductrice,
- étamage au trempé.

3. Bande de connexions selon la revendication 1, caractérisée en ce que les connexions extérieures (5,6) sont fendues, transversalement par rapport au ruban (1) par au moins une fente (19,20), afin de pouvoir les replier sur deux faces des composants CMS.

4. Bande de connexions selon la revendication 1, caractérisée en ce que deux jeux de connexions (5,6,9,10) découpés dans la ruban (1) sont séparés entre eux par une bande d'espacement (8), en vue de permettre le surmoulage (21) des composants CMS.

5. Bande de connexions selon la revendication 4, caractérisée en ce qu'une bande d'espacement (8) est munie d'au moins deux ergots latéraux (22,23), positionnés en un point tel que ces ergots soient au moins partiellement surmoulés en même temps que le composant CMS.

6. Bande de connexions selon la revendication 4, caractérisée en ce qu'une bande d'espacement (8) est munie d'au moins un ergot latéral (24), placé au milieu de ladite bande (8), afin de positionner la pastille (26) de composant avant sa soudure sur les surfaces à souder (9,10).

7. Bande de connexions selon la revendication 1, caractérisée en ce que le pliage (27,28) des connexions extérieures (5,6) et des languettes (11,12) est adapté, en position et en angle de pliage, aux dimensions de la pastille (26) de composant CMS.

FIG.1

FIG.2

FIG.3

FIG.4

FIG.5

FIG.6

FIG.7

FIG.8

FIG.9

FIG.10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-4497012 (ROGERS CORPORATION) <br> * le document en entier * <br> --- | 1, 2, 4-7 | H01G13/00 |
| A | EP-A-162149 (SIEMENS AG) <br> * page 1, ligne 3 - page 6, ligne 31; figures 1-16 * <br> --- | 1-7 | |
| A | US-A-4003125 (E.I.DU PONT DE NEMOURS & Co.) <br> * colonne 3, lignes 27 - 68; figure 2 * <br> --- | 1 | |
| A | EP-A-205360 (L.C.C.-C.I.C.E-COMPAGNIE EUROPEENNE DE COMPOSANTS ELECTRONIQUES) <br> * page 2, colonne 1, ligne 1 - page 3, colonne 3, ligne 50; figures 1, 2, 7-9, 13, 14 * <br> ----- | 1, 2, 4-7 | |

**DOMAINES TECHNIQUES RECHERCHES (Int. Cl.5 )**

H01L
H01G

Le présent rapport a été établi pour toutes les revendications

| Lieu de la recherche | Date d'achèvement de la recherche | Examinateur |
|---|---|---|
| LA HAYE | 07 MARS 1990 | CRIQUI J.J. |